# EUROPEAN PATENT APPLICATION

(11) **EP 4 632 240 A1**
(43) Date of publication of application: **15.10.2025**
(21) Application number: 25169518.5
(22) Date of filing: 09.04.2025
(51) Int. Cl.: F16B 5/02, F16B 31/00

(54) **THREADED SECUREMENT OF ENCLOSURE COMPONENTS**

(30) Priority: 10.04.2024 US 202463632243 P
(71) Applicant: Schroff GmbH, 75334 Straubenhardt (DE)
(72) Inventor: Gertz, Daniel, 67690 Hatten (FR); Thomas, Daniel, 67160 Seebach (FR)
(74) Representative: Barker Brettell LLP

(57) **Abstract**

An enclosure system (700) that can include a first component (702), a second component (706), and a self-threading screw (504, 508). The first component can include a first cutout (512, 516), the first cutout including a first internal perimeter that defines a first cutout interface (520, 530). The second component can include a second cutout (512, 516), the second cutout including a second internal perimeter that defines a second cutout interface (520, 530). The first cutout interface can be non-circular and include a first plurality of interface sides (528, 538). The self-threading screw can include a screw thread (522, 532). The self-threading screw can be threadedly-engaged with the first cutout interface and the second cutout interface to secure the first component on or within an enclosure (700), with a first plurality of discrete engagement portions (524, 534) of the screw thread threadedly engaging the first plurality of interface sides of the first cutout interface to secure the screw to the first component.

## Description

### BACKGROUND

It may be useful to mount different structural (and other) components together, including within enclosures for electrical devices. For example, support profiles can be secured to frame members of an enclosure and can themselves support various electrical devices or other installations.

### SUMMARY

Some examples of the disclosed technology include a method of securing components (e.g., for an enclosure). A first component can be aligned with a second component. The first component can be secured to the second component by driving a self-threading screw through a cutout that has a non-circular (e.g., polygonal) shape and is formed in one of the first component or the second component.

Some examples of the disclosed technology include an enclosure system. The system can include a first component, a second component, and a self-threading screw. The self-threading screw can threadedly engage a cutout in one of the first component or the second component, the cutout having a polygonal shape with side walls that engage threads of the self-threading screw.

Some examples of the disclosed technology include an enclosure system. The enclosure system can include a first component, a second component, and a self-threading screw that includes a screw thread. The first component can include a first cutout, the first cutout including a first internal perimeter that defines a first cutout interface. The second component can include a second cutout, the second cutout including a second internal perimeter that defines a second cutout interface. The first cutout interface can be non-circular and include a first plurality of interface sides. The self-threading screw can be threadedly-engaged with the first cutout interface and the second cutout interface to secure the first component on or within an enclosure, with a first plurality of discrete engagement portions of the screw thread threadedly engaging the first plurality of interface sides of the first cutout interface to secure the screw to the first component.

In some instances, the first plurality of interface sides can include at least three discrete interface sides. In some instances, the first plurality of discrete engagement portions can include at least three discrete engagement portions that are spaced apart from each other along the screw thread so that each of the at least three discrete engagement portions engages a discrete portion of a corresponding interface side of the at least three discrete interface sides.

In some instances, the at least three discrete interface sides of the first cutout interface can include a first interface side, a second interface side, and a third interface side, wherein the first interface side is adjacent to the second interface side and the third interface side. A first engagement portion of the first plurality of discrete engagement portions can engage the first interface side, a second engagement portion of the first plurality of discrete engagement portions can engage the second interface side, spaced apart from the engagement of the first engagement portion and first interface side, and a third engagement portion of the first plurality of discrete engagement portions can engage the third interface side, spaced apart from the engagement of the first engagement portion and first interface side and the engagement of the second engagement portion and the second interface side. The screw thread may not engage the first cutout interface between the engagement of the first engagement portion with first interface side and the engagement of the second engagement portion with the second interface side.

In some instances, the first cutout can be a rectangular cutout and the first plurality of interface sides can include four interface sides connected by four vertices, including a first interface side, a second interface side, a third interface side, and a fourth interface side, the first interface side being parallel to the third interface side, and the second interface side being parallel to the fourth interface side. The first plurality of discrete engagement portions of the screw thread can include four discrete engagement portions spaced apart from each other along the screw thread, including a first discrete engagement portion that engages the first interface side, a second engagement portion that engages the second interface side, a third engagement portion that engages the third interface side, and a fourth engagement portion that engages the fourth interface side.

In some instances, the second cutout interface can include a second plurality of interface sides. The self-threading screw can threadedly engage the second cutout interface, with a second plurality of discrete engagement portions of the screw thread threadedly engaging the second plurality of interface sides of the second cutout interface to secure the screw to the second component.

In some instances, the first plurality of discrete engagement portions of the screw thread can engage a first interface side of the first plurality of interface sides and a second interface side of the first plurality interface sides. The first interface side can be non-parallel to the second interface side.

In some instances, the first plurality of discrete engagement portions of the self-threading screw can extend radially into the first plurality of interface sides of the first cutout interface.

In some instances, the first component can be a support profile and the second component can be a frame member of the enclosure.

In some instances, the first component and second component, secured together by the self-threading screw, can define a support structure of the enclosure.

Some examples of the disclosed technology include an enclosure system. The system includes a first component that can include a first cutout, a second component that can include a second cutout, and a self-threading screw. The first cutout can define a first cutout interface. The self-threading screw that include a screw thread and can extend through the first and second cutouts to secure the first component to the second component. The first cutout can define a first polygonal shape that includes at least three interface sides, with a first interface side of the at least three interface sides being adjacent to a second interface side of the at least three interface sides. The self-threading screw can be threadedly-engaged with the first cutout of the first component, with at least three engagement portions of the screw thread engaging the at least three interface sides of the first cutout interface, so that the screw thread extends radially into the first component at discrete, spaced apart locations on the at least three interface sides of the first cutout interface.

In some instances, a first interface side of the first cutout interface can be adjacent to a second interface side and a third interface side of the first cutout interface. A first engagement portion of the at least three engagement portions can engage the first interface side, a second engagement portion of the at least three engagement portions can engage the second interface side, spaced apart from the engagement of the first engagement portion and first interface side, and a third engagement portion of the at least three engagement portions can engage the third interface side, spaced apart from the engagement of the first engagement portion and first interface side and the engagement of the second engagement portion and the second interface side. In some instances, the screw thread may not engage the first cutout interface between the engagement of the first engagement portion with first interface side and the engagement of the second engagement portion with the second interface side.

In some instances, the second cutout can define a second cutout interface that defines a second polygonal shape, and the self-threading screw can be threadedly engaged with a second cutout interface, with second at least three engagement portions of the screw thread separately engaging second at least three interface sides of the second cutout interface, so that the screw thread extends radially into the second component at discrete, spaced apart locations on the second at least three interface sides of the second cutout interface. In some instances, the first component can be a support profile and the second component is a frame member of an enclosure

In some instances, the first component can be a panel of an enclosure.

Some examples of the disclosed technology include an enclosure system. The system can include a first component, a second component, and a self-threading screw that can threadedly engage a cutout in one of the first component or the second component. The cutout can have a polygonal shape with a plurality of side walls that are separately engaged by a screw thread of the self-threading screw at a plurality of discrete engagement portions of the screw thread that are spaced apart from each other along the screw thread.

In some instances, the plurality of side walls can include at least three side walls. In some instances, the polygonal shape can be either of a rectangle, a pentagon, a hexagon, or a triangle.

In some instances, the plurality of discrete engagement portions of the screw thread can extend radially into the plurality of side walls. In some instances, the screw thread may not engage the plurality of side walls in between the plurality of discrete engagement portions.

Some examples of the disclosed technology include a method for engaging a first component and second component of an enclosure system. The method can include threadedly-engaging a self-threading screw with a cutout of a first component or a second component. The cutout can have a polygonal shape with a plurality of side walls that are separately engaged by a screw thread of the self-threading screw at a plurality of discrete engagement portions of the screw thread that are spaced apart from each other along the screw thread.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the system, screw or other component may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the disclosed technology and, together with the description, serve to explain the principles of examples of the disclosed technology:
FIG. 1 illustrates dimensions of a fastener configured as a self-threading screw;
FIG. 2 illustrates an example torque curve during assembly with the fastener of FIG. 1;
FIG. 3 illustrates fasteners installed within circular cutouts;
FIG. 4 illustrates a component with various cutouts according to some aspects of the disclosure;
FIG. 5 illustrates an example of the cutouts of FIG. 4 with fasteners installed within the cutouts, according to some aspects of the disclosure;
FIG. 6 displays a table with pull force results for a circular cutout and a square cutout according to some aspects of the disclosure; and
FIG. 7 illustrates an enclosure system with support members and profiles which may be fixed using a cutout from FIG. 4, according to some aspects of the disclosure.

### DETAILED DESCRIPTION

Before any examples of the disclosed technology are explained in detail, it is to be understood that the disclosure is not limited in its application to the details of construction and the arrangement of components set forth in the following description or illustrated in the following drawings. The disclosure is capable of other examples and of being practiced or of being carried out in various ways.

The following discussion is presented to enable a person skilled in the art to make and use examples of the disclosed technology. Various modifications to the illustrated examples will be readily apparent to those skilled in the art, and the generic principles herein can be applied to other examples and applications without departing from the disclosed technology. Thus, the disclosed technology is not intended to be limited to examples shown, but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of disclosed technology. Skilled artisans will recognize the examples provided herein have many useful alternatives and fall within the scope of the disclosed technology.

In various installations, components may be secured to enclosures. For example, a vertical profile, a mounting strip, a mounting plate, a door, or other components can be installed onto frame members or other structures of various enclosures (e.g., electrical cabinets, etc.). Components can be installed or secured to enclosures via fasteners (e.g., screws) including, in some installations, various types of self-threading fasteners (also known as self-tapping screws). A self-threading fastener (e.g., a self-threading screw) is a fastener that forms threading into the material that surrounds and defines an aperture into which the fastener is being rotatably driven, as opposed to a fastener that is configured to engage pre-formed threads (e.g., on a tapped hole or threaded insert). In other words, as generally known in the art, a self-threading fastener can be rotatably driven into a non-threaded aperture to secure the self-threaded fastener (and other components) to a structure that includes the aperture.

During some installation, a screwing machine may be utilized, including drivers that can be automatically controlled and electrically, pneumatically, or otherwise powered. Conventionally, a screwing machine can be operated with a set torque, so that the screwing machine can apply torque within a relatively small range around a target torque (e.g., ±15% relative to a selected set-point).

In some installations, enclosures or other structures can include cutouts (i.e., cut or otherwise formed closed-sided apertures) and self-threading fasteners can be installed through the cutouts of the enclosure (e.g., to secure other components). In some installations, a component may include a cutout through which self-threading fasteners are installed to secure the component to another structure (e.g., to secure components on or within an enclosure).

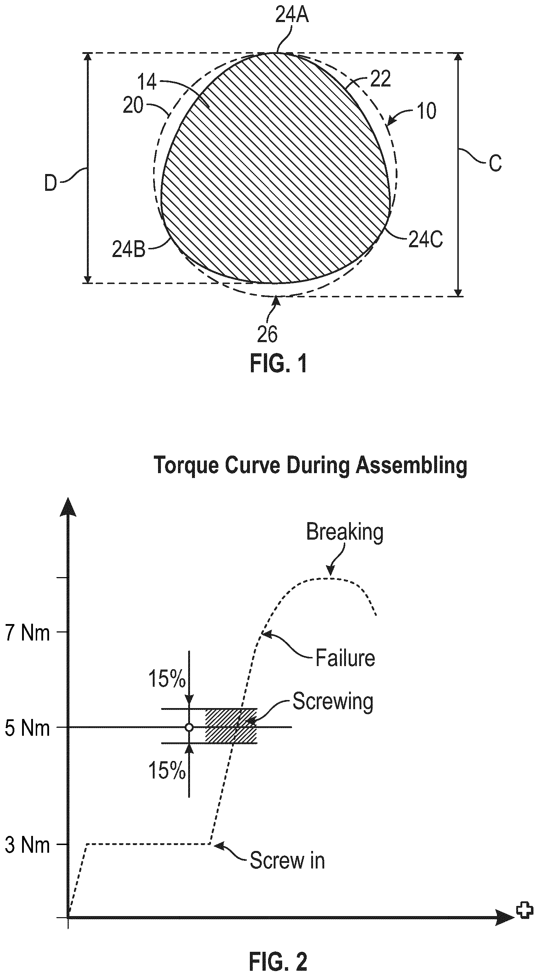

As one example, FIG. 1 shows a cutout 10 that can be provided in any number of components (e.g., an enclosure frame or other support member) and a fastener 14 received in the cutout 10. The cutout 10 defines a (maximum) cutout dimension C and the fastener 14 defines a (maximum) fastener dimension D. Herein, the cutout dimension C may generally describe a diameter of a cutout, an equivalent diameter of a cutout if the cutout is not circular, or, in some cases, a maximum dimension of the cutout along a plane perpendicular to a axial direction of a screw that is inserted through the cutout. In the illustrated example, the cutout dimension C may also correspond to the circumscribed diameter of the fastener 14 during rotation thereof.

The cutout 10 defines an internal perimeter that corresponds to a cutout interface 20 at which a threaded fastener that is inserted through the cutout 10 can engage the corresponding component. In the illustrated example, the cutout interface 20 extends fully and continuously around the internal perimeter of the cutout 10 to define a geometric shape of the cutout 10. In some examples, as shown in FIG. 1, the cutout interface 20 defines the geometric shape of a circle. However, non-circular profiles for cutouts can provide notable and unexpected improvements over conventional approaches, as further detailed below.

Similarly to the cutout 10, the fastener 14 defines a fastener perimeter (e.g., a fastener circumference) that provides a fastener interface 22 (e.g., a continuous screw thread, particularly a single continuous screw thread, in typical configurations). The fastener interface 22 circumscribes the fastener 14 to form a geometric shape of the fastener 14 as viewed in cross-section, which will be discussed in further detail below. In some examples, as shown in FIG. 1, the fastener interface 22 defines the geometric shape of an ellipse relative to a cross-section of the fastener 14 taken perpendicularly to the axial (or insertion) direction of the fastener 14 (e.g., corresponding to a standard spiral screw thread).

To threadedly secure the fastener 14 at the cutout 10, the cutout interface 20 may contact portions of the fastener 14. Specifically, as shown in the example installation of FIG. 1, the cutout interface 20 is in contact with one or more discrete engagement portions 24A, 24B, 24C of the fastener interface 22 (also referred to herein simply as "engagement portions 24"). In some examples, as shown in FIG. 1, the cutout interface 20 and the engagement portions 24 are in contact with each other. In some examples, and as discussed in more detail below, the engagement portions 24 may extend past (e.g., through) the exposed surface of the cutout interface 20 and into the material of a component that includes the cutout 10.

In some examples, the engagement portions and the cutout interface may not be in contact for an entire periphery of the fastener. For example, as shown in FIG. 1, the fastener 14 and the cutout interface 20 are not in contact, nor do the engagement portions 24 extend past the cutout interface 20. In such examples, the fastener 14 and the cutout 10 define gaps 26 between discrete engagement areas between the fastener interface 22 and the cutout interface 20, corresponding to regions with no contact between the interfaces 20, 22, extending between spaced apart regions of contact between the interfaces 20, 22. The gaps 26 may be present anywhere along the external perimeter of the fastener 14 (i.e., along the fastener interface 22 as shown) and the internal perimeter of the cutout 10 (i.e., along the cutout interface 20 as shown), depending on the particular configuration of the fastener interface 22 (e.g., screw thread) and the cutout interface 20. In other words, the gaps 26 may be formed due to a combination of the geometry of the fastener 14 and the cutout 10.

It may be relatively difficult to install components using conventional fasteners, cutouts, and installation tools - particularly when the component includes relatively thick material (e.g., sheet metal over 3 millimeters (mm) in thickness). For example, when the component includes sufficiently thick material (e.g., equal to or greater than 3 mm in thickness), the necessary torque required to install a self-threading fastener may be sufficiently close to the torque that will cause the fastener connection to fail (e.g., to over-cut the threads through over-rotation) that it may not be possible to install the fastener with conventional machines.

More particularly, when installing a self-threading fastener to a component with a cutout, there can be multiple stages. In a first stage, or the "screw in" stage during assembly, the self-threading fastener is just beginning to screw into the cutout - and to correspondingly cut threads into the corresponding cutout interface (e.g., circular internal perimeter surface). In some instances, the screw in stage has a screw-in torque, e.g., the minimum torque required for the self-threading fastener to appropriately engage with the component. In an example screw in stage for component assembly, as shown in FIG. 2, the screw-in torque is 3 Newton-meters (Nm). In other words, when 3 Nm of torque is applied, the screw of the example will begin to cut threads into the cutout. In other instances, a self-threading fastener may exhibit a screw-in torque that is higher or lower than the torque shown in FIG. 2.

In a second stage of installation of the self-threading fastener, threads of the fastener are fully engaged with the cutout, and the fastener is advanced along cut threads in the material of the cutout interface to secure the fastener - and thereby, for example, a corresponding component. This can be referred to as the "screwing" stage of assembly. During the screwing stage, the self-threading fastener may experience a screwing torque applied by a screwing machine (e.g., a relatively constant torque). In the example assembly shown in FIG. 2, during the screwing stage of assembly, the screwing torque is set to 5 N-m with a 15% tolerance range on either side of the screwing torque. In other instances, the tolerance range may be higher or lower than the 15% tolerance range shown in FIG. 2. In other instances, the fastener may experience a screwing torque that is higher or lower than the torque shown during the screwing stage in FIG. 2.

In a third stage of assembly, the fastener may experience failure as excessive torque causes a failure in the engagement of the fastener with the material of the cutout interface (e.g., such that the screw over-cuts the threads at the cutout interface). In the example assembly shown in FIG. 2, the failure torque is 7 N-m. In other words, if torque of 7 N-m or more is applied to the fastener, failure is likely to result. In other instances, the failure torque may be higher or lower than the failure torque shown during the failure stage of FIG. 2.

In some instances, including where the material around a cutout is relatively thick, the screw-in (or screwing) torque may be increased sufficiently so as to exceed the maximum end of a tolerance range for machine-applied torque during the screwing stage. In such cases, for example, the screwing machine may not be able to apply sufficient screw-in torque at a desired set point, or application of sufficient screw-in torque may result in (or require) a tolerance range for screwing torque that approaches (or exceeds) the failure torque.

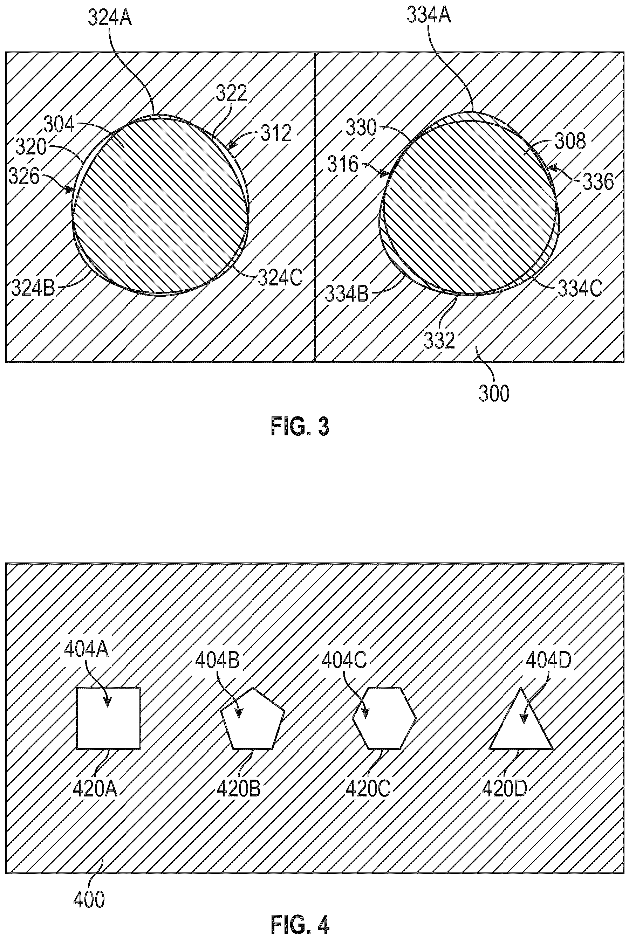

For example, a first fastener 304 (a self-threading fastener) and a second fastener 308 (a self-threading fastener), shown in conventional installation in FIG. 3, may experience a screw-in torque that is overly close to a failure torque with corresponding increase in difficulties during assembly. The first fastener 304, when installed in a first (circular) cutout 312 in a component 300 (e.g., with a 3 mm thickness), requires a screw-in torque of 4.66 N-m during the screw in stage and has a minimum failure torque of 5.02 N-m. The second fastener 308, when installed in a second (circular) cutout 316 (e.g., also at an area of 3 mm thickness), experiences a screw-in torque of 5.26 N-m, and has a minimum failure torque of 6.18 N-m. In the first fastener 304 and second fastener 308, the screw-in torque is sufficiently close to the failure torque, that operation of a screwing machine to provide the required screw-in torque may cause the machine to also provide levels of torque that may cause failure during installation. Thus, when self-threading fasteners are installed to the component 300 in the conventional cutouts 312, 316 (e.g., at a local 3mm thickness), the fasteners may be subject to failure. Correspondingly, the fasteners 304, 308 may no longer secure the component 300, or secure other components (not shown) thereto, as desired.

Unexpectedly, it has been determined that the screw-in torque may be sufficiently close to failure torque in these and other similar arrangements due to the geometry of the fastener and the cutout. For example, the cutout 312 includes a circular internal perimeter that correspondingly defines a circular cutout interface 320, and the fastener 304 defines a fastener interface 322 (e.g., self-tapping screw thread) that is elliptical in cross-section (perpendicular to the insertion direction of the fastener 304). Correspondingly, the fastener interface 322 includes engagement portions 324A, 324B, 324C (engagement portions 324, herein) that contact, and extend past the cutout interface 320 (i.e., into the material of the component 300 that surrounds the cutout 312). In some examples, such as the example of FIG. 3, the engagement portions 324 of fastener 304 extend 0.14 mm past the cutout interface 320. As similarly discussed above, the fastener interface 322 and the cutout interface 320 inter-engage to define gaps 326 where the engagement portions 324 do not contact, nor extend past, the cutout interface 320. In particular, in the example of FIG. 3, this configuration results from the cutout 312 having a diameter of 5.7 mm, and the fastener 304 defining a screw diameter of 5.77 mm (e.g., corresponding dimension D in FIG. 1) and a circumscribed diameter of 5.97 mm (e.g., corresponding to dimension C in FIG. 1). (The cutout 10 and fastener 14 of FIG. 1 are similar to the cutout 312 and fastener 304 of FIG. 3, and, thus, the description of the cutout 10 and fastener 14 of FIG. 1 is also applicable to the cutout 312 and fastener 304 of FIG. 3, and vice versa).

Still referring to FIG. 3, the cutout 316 includes similar geometry as the cutout 312 and the fastener 308 includes similar geometry as the fastener 304. For example, the cutout 316 includes a circular cutout interface 330 and the fastener 308 defines a fastener interface 332 (e.g., self-tapping screw thread) that is elliptical in cross section. The fastener interface 332 includes engagement portions 334A, 334B, 334C (engagement portions 334, herein) that contact, and extend past the cutout interface 330. In some examples, including the example of FIG. 3, the engagement portions 334 of fastener 308 extend 0.25 mm past the cutout interface 330. As similarly discussed above, the fastener interface 332 and the cutout interface 330 define one or more gaps 336 where the engagement portions 334 do not contact, nor extend past, the cutout interface 330. In particular, in the example of FIG. 3, this configuration results from the cutout 316 having a diameter of 5.6 mm, and the fastener 308 defining a screw diameter of 5.90 mm (e.g., corresponding dimension D in FIG. 1) and a circumscribed diameter of 6.1 mm (e.g., corresponding to dimension C in FIG. 1).

Some examples of the disclosed technology can address these or other issues through improved configuration of cutout interfaces with respect to corresponding fastener interfaces (e.g., screw threads, and in particular self-tapping screw threads). For example, some configurations include cutouts that have polygonal or other non-circular shapes, with correspondingly arranged discrete cutout sides (e.g., each connected to another by an intervening vertex and corresponding vertex angle). Unexpectedly, it has been found that this approach provides improved installation characteristics, including to allow for self-threading fasteners to be installed, without failure, to thick components (e.g., of 3 mm or more).

In some examples, a polygonal cutout can be a square aperture that is cut, stamped, punched, or otherwise formed in a metal (or other) component. Further, in some examples, the polygonal cutouts may have shapes including a rectangle, a pentagon, a hexagon, triangle, or any other polygonal shape. For example, as shown in FIG. 4, a component 400 according to an example of the disclosed technology can include a rectangular (e.g., square) cutout 404A, a pentagonal cutout 404B, a hexagonal cutout 404C, and a triangular cutout 404D (or one or more of any of the cutouts 404A, 404B, 404C, 404D in various combinations, arrays, etc.). Each cutout 404A-404D includes an internal perimeter that defines a corresponding cutout interface 420A, 420B, 420C, and 420D, respectively. Thus, the cutout interface defines the polygonal shape of the respective cutout.

As noted above, in some examples, a polygonal cutout interface includes a plurality of discrete interface sides connected by corresponding vertices. For instance, a cutout with a cutout interface in the polygonal shape of a rectangle would include four interface sides (e.g., four linear sides), with four corresponding vertices to connect adjacent interface sides. Similarly, a cutout with a cutout interface in the polygonal shape of a hexagon would include six discrete interface sides (e.g., six linear sides), with six corresponding vertices. In contrast, a cutout with a cutout interface in the shape of a circle would not include a plurality of discrete interface sides, but rather only one continuous interface side.

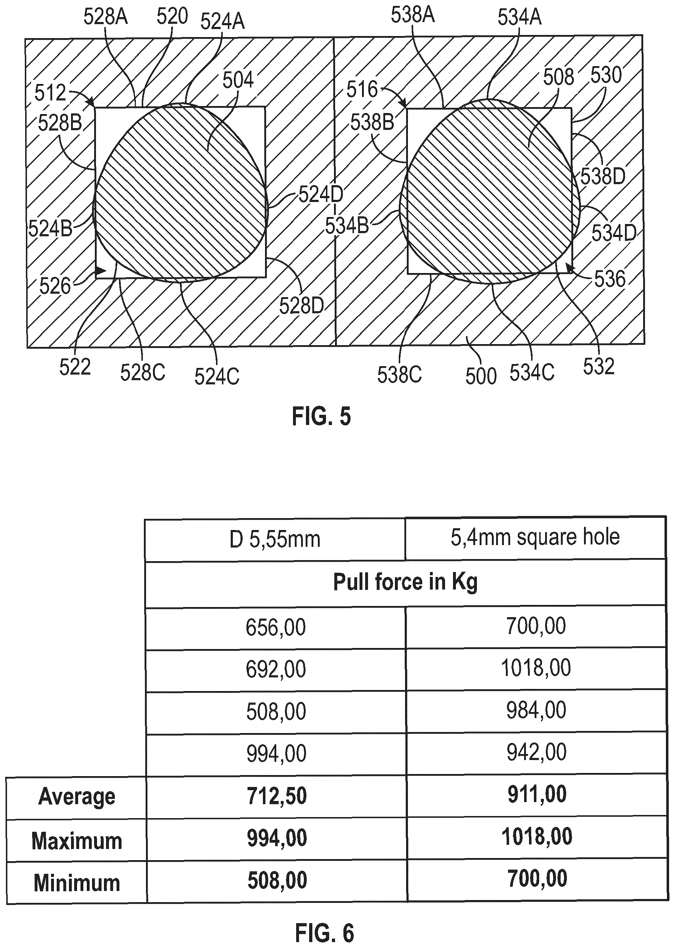

For instance, as shown in the example of FIG. 5, a first polygonal cutout 512 in a component 500 defines a rectangular (e.g., square) polygonal shape of a cutout interface 520. Correspondingly, in this example, the cutout interface 520 includes an interface side 528A (e.g., first interface side), an interface side 528B (e.g., second interface side), an interface side 528C (e.g., third interface side), and an interface side 528D (e.g., fourth interface side) (collectively, interface sides 528, herein). In the depicted example in FIG. 5, the interface side 528A and the interface side 528C are parallel to each other and perpendicular to the second side 528B and the fourth side 528D, whereas the second side 528B and fourth side 528D are parallel to each other. However, other configurations are possible. In some examples, the sides 528 are all the same length. In other examples, the interface sides 528A, 528C are the same length and the interface sides 528B, 528D are the same length, but the interface side 528A and the interface side 528B have different lengths.

Similar to FIG. 3, when a fastener 504 is installed in the component 500 via the cutout 512, a fastener interface 522 (e.g., screw thread) defines engagement portions 524A, 524B, 524C, 524D at which the fastener interface 522 engages the interface sides 528. In the illustrated example, the fastener 504 is similarly dimensioned as the fastener 304, although other configurations are possible. However, due to the geometry of the cutout 512, the fastener interface 522 as installed defines additional discrete engagement portions of the fastener interface 522 that contact, or penetrate through, the various interface sides 528 of the cutout interface 520. Additionally, as discussed above, the fastener interface 522 and the cutout interface 520 define a one or more gaps 526 where the engagement portions 524 do not contact, nor extend past, the cutout interface 520. In other words, the fastener interface 522 threadedly engages the cutout interface 520 over a plurality of discrete engagement portions of the fastener interface 522, which are spaced apart from each other. Correspondingly, the fastener interface 522 engages the cutout interface 520 over discrete portions of the cutout interface 520 that are spaced apart from each other around the cutout interface, and does not engage the cutout interface 520 over intervening sections of the fastener interface 522 and the cutout interface 520.

Similar to fastener 504, fastener 508 includes a fastener interface 532 configured as a screw thread (e.g., self-tapping screw thread). Further, similar to cutout 512, cutout 516 is defines a cutout interface 530 that is a rectangular (e.g., square) polygonal shape. Further, in this example, the cutout interface 530 includes an interface side 538A (e.g., first interface side), an interface side 538B (e.g., second interface side), an interface side 538C (e.g., third interface side), and an interface side 538D (e.g., fourth interface side) (collectively, interface sides 538, herein). Similar to cutout 312, the first side 538A and the third side 538C are parallel and perpendicular to the second side 528B and the fourth side 528D, where the second side 528B and fourth side 528D are parallel. As similarly discussed above, the fastener interface 532 correspondingly engages discrete, spaced-apart portions of the cutout interface 530 via discrete engagement portions 534A, 534B, 534C, 534D of the engagement interface 532, spaced apart from each other along the engagement interface 532 (e.g., screw thread). Further, as similarly discussed above, the fastener 508 and the cutout interface 530 thus define a one or more gaps 536 between the protrusion of the engagement portions 534A, 534B, 534C, 534D into the material of the component 500 that defines the cutout interface 530.

Unexpectedly, the use of polygonal shapes for cutout interfaces in thick (or other) components, including rectangular (e.g., square) interfaces as detailed above, allow for threaded (e.g., self-threading) fasteners to experience acceptably low screw-in torques during installation, without adverse loss of holding strength. Indeed, as detailed below, holding strength can in some cases be improved as compared to conventional approaches. The use of polygonal cutout interfaces to engage screw threads can also provide for relatively high failure torques. Correspondingly, in an unexpected improvement over conventional approaches, screwing machines can be reliably operated to provide constant torque that is more than sufficient for screw-in torque and far below failure torque.

For instance, in the first polygonal cutout 512 in the component 500, as shown in FIG. 5, the first fastener 504 (a self-threading fastener) requires a screw-in torque of 2.26 N-m and has a minimum failure torque of 8.26 N-m. Thus, the failure torque is nearly four times the screw-in torque. Further, in the second polygonal cutout 516 shown in FIG. 5, the second fastener 508 (a self-threading fastener) requires a screw-in torque of 2.94 N-m and has a minimum failure torque of 11.68 N-m. Thus, the first fastener 504 and second fastener 508 have a lower screw-in torque requirement to begin installation and, surprisingly, also have a higher failure torque than with conventional approaches (e.g., with failure torque nearly four times higher than screw-in torque, as compared to failure torque that exceeds screw-in torque by only 10-15% in conventional approaches). Accordingly, for example, a screwing machine can be operated with a 5 N-m set point to provide more than sufficient screw-in torque while remaining well below failure torque (e.g., even during operation of a screwing machine within a ±15% tolerance range around a torque set point).

Also unexpectedly, as noted above, polygonal cutouts may increase the strength of the installation when compared to a standard circular cutout. For example, the installed self-threading fastener may exhibit greater pull-out strength in a polygonal cutout than in a similar circular cutout. In this regard, in an example test procedure, a self-threading fastener was installed to a circular cutout with a diameter of 5.55 mm and an equivalent self-threading fastener was installed to a square cutout with a width of 5.4 mm. A pull force was then applied to the fastener as installed in the circular cutout and installed in the polygonal cutout to test for pull-out failure. Surprisingly, as shown in the table of FIG. 6, the average pull-out force for the square cutout was significantly higher than the average pull-out force for the circular cutout. Further, the maximum and minimum pull-out forces for the square cutout were also significantly higher than for the circular cutout. Similar results are correspondingly expected to obtain for other similarly dimensioned circular and polygonal cutouts.

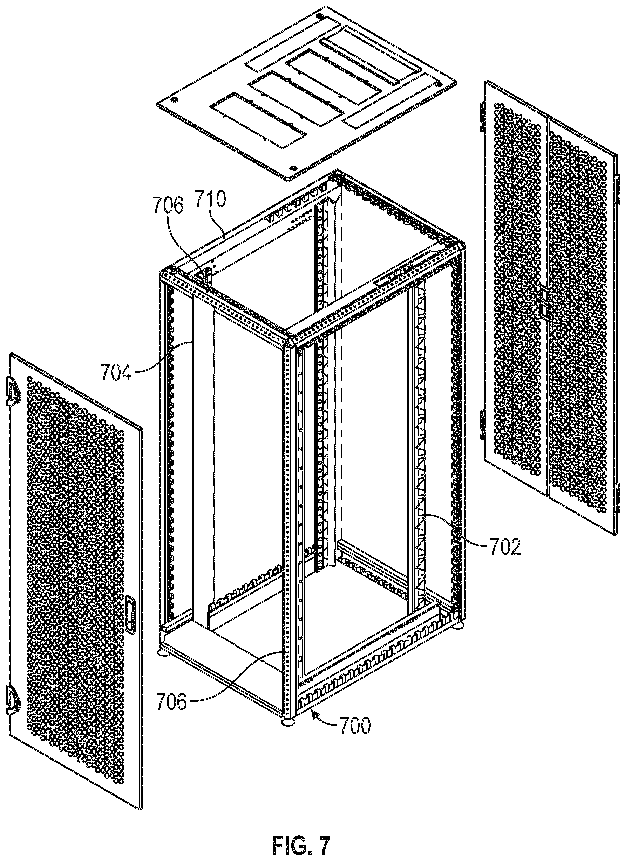

As previously discussed, self-threading fasteners may secure a variety of components with polygonal cutouts to enclosures or other structures. For example, as shown in FIG. 7, self-threading fasteners may secure a vertical (or other) support profile 702 or panel 704 to any variety of structures in an enclosure 700, including various of frame members 706 and 710 or other structures as generally known in the art. In particular, inclusion of polygonal cutouts on the profile 702, the panel 704, the frame members 706, or various other structures can provide improved versatility and ease of assembly, as generally discussed above. In some examples, the frame member 706 is a vertical frame member and defines a vertical support. In other examples, the frame member 710 is a horizontal frame member and defines a horizontal support. Thus, example of the disclosed technology can provide improved systems and methods for installing a self-threading fastener to a thick component. For example, as detailed above, some configurations can allow for torque measurements that avoid issues during the screw in stage and failure stage.

It is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "substantially parallel" indicates a direction that is within ± 12 degrees of a reference direction (e.g., within ± 6 degrees or ± 3 degrees), inclusive. Similarly, unless otherwise limited or defined, "substantially perpendicular" similarly indicates a direction that is within ± 12 degrees of perpendicular a reference direction (e.g., within ± 6 degrees or ± 3 degrees), inclusive. Correspondingly, "substantially vertical" indicates a direction that is substantially parallel to the vertical direction, as defined relative to the reference system (e.g., a local direction of gravity, by default), with a similarly derived meaning for "substantially horizontal" (relative to the horizontal direction). Discussion of directions "transverse" to a reference direction indicate directions that are not substantially parallel to the reference direction. Correspondingly, some transverse directions may be perpendicular or substantially perpendicular to the relevant reference direction.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either of," "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of" (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Also as used herein, unless otherwise limited or defined, "integral" and derivatives thereof (e.g., "integrally") describe elements that are manufactured as a single piece without fasteners, adhesive, or the like to secure separate components together. For example, an element that is stamped, cast, or otherwise molded as a single-piece component from a single piece of sheet metal or using a single mold, without rivets, screws, other fasteners, or adhesive to hold separately formed pieces together is an integral (and integrally formed) element. In contrast, an element formed from multiple pieces that are separately formed initially then later connected together, is not an integral (or integrally formed) element.

As used herein, unless otherwise limited or specified, "substantially identical" refers to two or more components or systems that are manufactured according to the same process and specification, with variation between the components or systems that are within the limitations of acceptable tolerances for the relevant process or specification. For example, two components can be considered to be substantially identical if the components are manufactured according to the same standardized manufacturing steps, with the same materials, and within the same acceptable dimensional tolerances (e.g., as specified for a particular process or product).

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

In some implementations, devices or systems disclosed herein can be utilized, manufactured, installed, etc. using methods embodying aspects of the disclosed technology. Correspondingly, any description herein of particular features, capabilities, or intended purposes of a device or system should be considered to disclose, as examples of the disclosed technology a method of using such devices for the intended purposes, a method of otherwise implementing such capabilities, a method of manufacturing relevant components of such a device or system (or the device or system as a cutout), and a method of installing disclosed (or otherwise known) components to support such purposes or capabilities. Similarly, unless otherwise indicated or limited, discussion herein of any method of manufacturing or using for a particular device or system, including installing the device or system, should be understood to disclose, as examples of the disclosed technology, the utilized features and implemented capabilities of such device or system.

Correspondingly, some implementations can include methods of assembling enclosure systems, or otherwise connected two components together with a screw fastener (e.g., a self-threading screw), as generally illustrated in FIG. 7, with further reference to the elements illustrated in FIG. 5 and corresponding discussion. For example, an enclosure system can be assembled by providing a first component that includes a first cutout, with the first cutout including a first internal perimeter that defines a first cutout interface. A second component can also be provided, with the second component including a second cutout, and the second cutout including a second internal perimeter that defines a second cutout interface. In some examples, one or more of the first cutout interface or the second cutout interface can be non-circular (e.g., polygonal) and can include a corresponding plurality of interface sides. A fastener (e.g., a self-threading screw) can be threadedly engaged with the first cutout interface and the second cutout interface to secure the first component to the second component on or within an enclosure, with a plurality of discrete engagement portions of the screw thread threadedly engaging one or more of a first plurality of interface sides of the first cutout interface or a second plurality of interface sides of the second cutout interface to secure the screw to the first component.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the system, screw or other component described may be incorporated into/used in a corresponding method and vice versa.

The previous description of the disclosed examples is provided to enable any person skilled in the art to make or use the disclosure. Various modifications to these examples will be readily apparent to those skilled in the art, and the generic principles defined herein may be applied to other examples without departing from the spirit or scope of the disclosed technology. Thus, the disclosure is not intended to be limited to the examples shown herein but is to be accorded the widest scope consistent with the principles and novel features disclosed herein.

## Claims

1. An enclosure system (700) comprising:
a first component (702) that includes a first cutout (512, 516), the first cutout including a first internal perimeter that defines a first cutout interface (520, 530);
a second component (706) that includes a second cutout (512, 516), the second cutout including a second internal perimeter that defines a second cutout interface (520, 530); and
a self-threading screw (504, 508) that includes a screw thread (522, 532),
the first cutout interface being non-circular and including a first plurality of interface sides (528, 538), and
the self-threading screw being threadedly engaged with the first cutout interface and the second cutout interface to secure the first component to the second component on or within an enclosure (700), with a first plurality of discrete engagement portions (524, 534) of the screw thread threadedly engaging the first plurality of interface sides of the first cutout interface to secure the screw to the first component.

2. The enclosure system of claim 1, wherein the first plurality of interface sides includes at least three discrete interface sides.

3. The enclosure system of claim 2, wherein the first plurality of discrete engagement portions includes at least three discrete engagement portions that are spaced apart from each other along the screw thread so that each of the at least three discrete engagement portions engages a discrete portion of a corresponding interface side of the at least three discrete interface sides.

4. The enclosure system of claim 2, wherein the at least three discrete interface sides of the first cutout interface includes a first interface side (528A, 538A), a second interface side (528B, 538B), and a third interface side (528D, 538D), wherein the first interface side is adjacent to the second interface side and the third interface side,
wherein a first engagement portion (524A, 534A) of the first plurality of discrete engagement portions engages the first interface side, a second engagement portion (524B, 534B) of the first plurality of discrete engagement portions engages the second interface side, spaced apart from the engagement of the first engagement portion and first interface side, and a third engagement portion (524D, 534D) of the first plurality of discrete engagement portions engages the third interface side, spaced apart from the engagement of the first engagement portion and first interface side and the engagement of the second engagement portion and the second interface side, and
wherein the screw thread does not engage the first cutout interface between the engagement of the first engagement portion with first interface side and the engagement of the second engagement portion with the second interface side.

5. The enclosure system of claim 1, wherein the first cutout is a rectangular cutout and the first plurality of interface sides includes four interface sides connected by four vertices, including a first interface side (528A, 538A), a second interface side (528B, 538B), a third interface side (528C, 538C), and a fourth interface side (528D, 538D), the first interface side being parallel to the third interface side, and the second interface side being parallel to the fourth interface side; and
wherein the first plurality of discrete engagement portions of the screw thread includes four discrete engagement portions spaced apart from each other along the screw thread, including a first discrete engagement portion (524A, 534A) that engages the first interface side, a second engagement portion (524B, 534B) that engages the second interface side, a third engagement portion (524C, 534C) that engages the third interface side, and a fourth engagement portion (524D, 534D) that engages the fourth interface side.

6. The enclosure system of either of claims 1 or 5, wherein the second cutout interface includes a second plurality of interface sides (528, 538); and
wherein the self-threading screw threadedly engages the second cutout interface, with a second plurality of discrete engagement portions of the screw thread threadedly engaging the second plurality of interface sides of the second cutout interface to secure the screw to the second component.

7. The enclosure system of any of claims 1 through 3, 5 or 6, wherein the first plurality of discrete engagement portions of the screw thread engage a first interface side of the first plurality of interface sides and a second interface side of the first plurality interface sides and
wherein the first interface side is non-parallel to the second interface side.

8. The enclosure system of any of the preceding claims, the first plurality of discrete engagement portions of the self-threading screw extend radially into the first plurality of interface sides of the first cutout interface.

9. The enclosure system of any of the preceding claims, wherein the first component is a support profile and the second component is a frame member of the enclosure.

10. The enclosure system of any of the preceding claims, wherein the first component and second component, secured together by the self-threading screw, define a support structure of the enclosure.

11. A method for engaging a first component (702) and second component (706) of an enclosure system (700), the method comprising:
threadedly-engaging a self-threading screw (504, 508) with a cutout (512, 516) of the first component or the second component, the cutout having a polygonal shape with a plurality of side walls (528, 538) that are separately engaged by a screw thread (522, 532) of the self-threading screw at a plurality of discrete engagement portions (524, 534) of the screw thread that are spaced apart from each other along the screw thread.

12. The method of claim 11, wherein the plurality of side walls includes at least three side walls.

13. The method of claim 12, wherein the polygonal shape is either of a rectangle, a pentagon, a hexagon, or a triangle.

14. The method of any of claims 11 through 13, wherein the plurality of discrete engagement portions of the screw thread extend radially into the plurality of side walls.

15. The method of claim 14, wherein the screw thread does not engage the plurality of side walls in between the plurality of discrete engagement portions.
